# EUROPEAN PATENT APPLICATION

(11) **EP 2 348 325 A1**
(43) Date of publication of application: **27.07.2011**
(21) Application number: 08877288.4
(22) Date of filing: 10.10.2008
(51) Int. Cl.: G01R 15/18

(54) **MAGNETIC BRIDGE FOR SENSOR USING MAGNETIC FLUID, AND CURRENT SENSOR AND MAGNETIC SENSOR USING THE MAGNETIC BRIDGE**

(71) Applicant: Tadatsu, Takashi, Fukuoka 811-3114 (JP); Yugenkaisha YY Office, Tokyo 105-0021 (JP)
(72) Inventor: TADATSU, Takashi, Fukuoka 8113114 (JP)
(74) Representative: Herrmann, Uwe
(86) International application number: PCT/JP2008/068501
(87) International publication number: WO 2010/041340

(57) **Abstract**

The present invention provides a sensor in which an offset problem of the sensor can be solved, that is, a current sensor, a magnetic field sensor, a magnetic bridge that is formed by a magnetic fluid suitably used in the current sensor and the magnetic field sensor, and a magnetic path casing that forms the magnetic fluid whose form is unfixed into a required morphologic magnetic bridge. The magnetic bridge includes a magnetic circuit in which two separated circular magnetic paths mr1 and mr2 are connected by connection magnetic paths cr1 and cr2 made of magnetic materials, the circular magnetic paths mr1 and mr2 being formed by retaining a shape of a magnetic fluid with a container 11, and excitation coils L1 and L2 that are driven by excitation driving means while wound on the connection magnetic paths cr1 and cr2. In the magnetic bridge, a magnetic resistance in the magnetic circuit is appropriately selected to express a magnetic equilibrium state in which a sum of magnetic fluxes of the two circular magnetic paths mr1 and mr2 becomes zero (the magnetic fluxes differ from each other in a direction while being equal to each other in magnitude).

## Description

### TECHNICAL FIELD

The present invention relates to a current sensor that measures a current while remaining in an insulating state without connecting to a detected lead, particularly to a wide-dynamic-range current sensor that can measure a weak current while completely removing an offset that is difficult to remove in a conventional large direct current sensor, a magnetic bridge in which a magnetic fluid used in a configuration of the current sensor is used, and a magnetic field sensor in which the magnetic bridge is used.

### BACKGROUND ART

A Hall element type direct current sensor in which a magnetic sensing element is used can be cited as a typical example of the well-known insulating type direct current sensor, and a flux-gate current sensor, widely called a magnetic modulation system, in which a magnetic characteristic of a magnetic material is used can be cited as a typical example of the insulating type direct current sensor. The magnetic sensing element typified by the Hall element type direct current sensor is suitable to measure a large current. The magnetic modulation system typified by the flux-gate type direct current sensor is suitable to detect a weak current although the magnetic modulation system is not suitable to detect the large current.

The Hall element type current sensor has a structure, in which part of a ring made of a soft magnetic material having high permeability is cut and opened to form a yoke having a gap and a Hall element is placed in the gap (the current sensor in which the magnetic sensing element is used has basically the same structure). However, the soft magnetic material constituting the yoke has a hysteresis characteristic to generate residual magnetization, which causes an offset error. This is a common drawback in the system in which the yoke and the magnetic sensing element are used.

Only the soft magnetic material having the high permeability is used as the material for the yoke, and the residual magnetization is generated in any soft magnetic material used as the material for the yoke. That is, from the viewpoints of both the residual magnetization problem and the low sensitivity, it is difficult to measure the weak current with the Hall element type current sensor that is suitable to measure the large current. Therefore, in the Hall element type current sensor, it is difficult to produce a current sensor having a wide dynamic range.

In the flux-gate type current sensor, a detection function is exhibited by saturating magnetization of the part or whole of the ring magnetic material. Therefore, a magnetic material whose magnetization is not saturated by a measured current is used as the material for the flux-gate type current sensor, and it is necessary to saturate the magnetization of the magnetic material with a magnetic field stronger than that of the measured current. When the large current is measured, it is necessary to perform magnetic excitation with a current larger than the measured large current, and therefore the flux-gate type current sensor is impractical due to heat generation and large power consumption.

Recently, environmental preservation becomes a social problem, significance of the direct current such as photovoltaic generation and a fuel cell is enhanced, and a demand for a direct-current power device such as an electric car and a hybrid car in which a secondary battery is used is expected to increase. From the viewpoint of energy saving, in the field where a conventional shunt resistor is used, desirably the current is detected by the magnetic field in which energy consumption is brought close to zero. In a direct-current high voltage circuit used in a high-voltage electron tube and the like, although the current tends to decrease because of the high voltage, it is frequently convenient that the current of the high voltage circuit is measured in the insulating state.

However, a general-purpose, inexpensive current sensor having the sensitivity and dynamic range that can correspond to the demand and a current detection method do not exist in the conventional sensor technologies.

In view of the problem of the conventional sensor technologies, the inventor has proposed techniques of Japanese Patent Application Nos. 2002-176894, 2003-101353, and 2004-513784 in order to solve the problem.

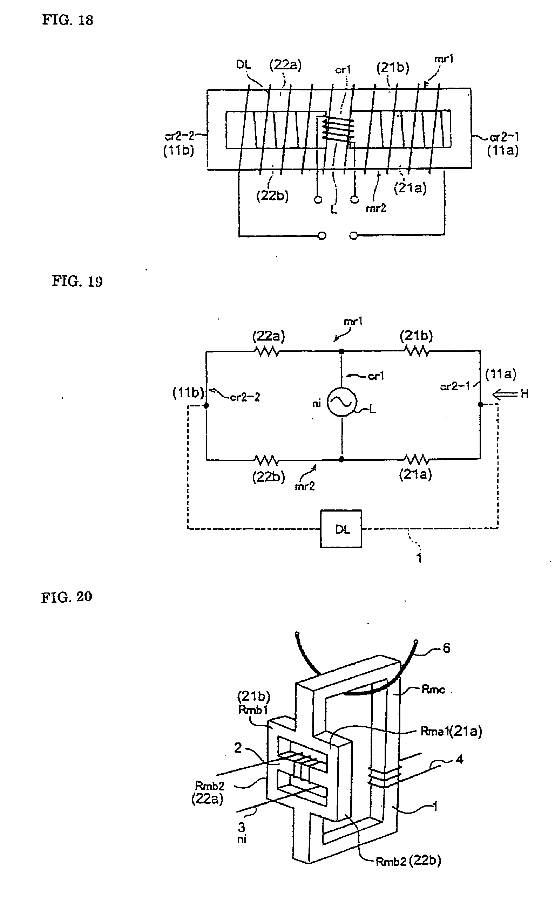

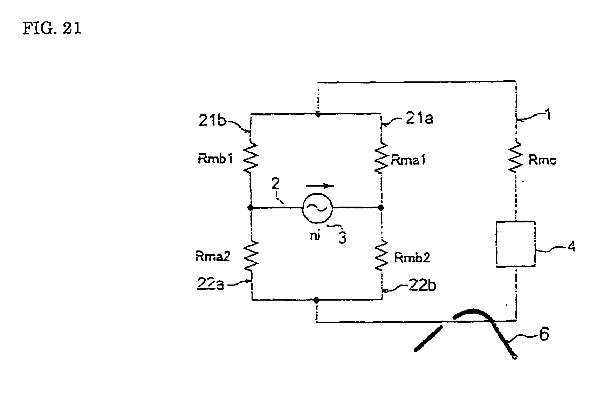

As illustrated in FIGS. 20 and 21, an example of the proposed techniques includes one magnetic circuit 1 having both ends, magnetic circuits 21a and 21b having both ends in which one end of each of the magnetic circuits 21a and 21b is connected to one end of the magnetic circuit 1, magnetic circuits 22b and 22a having both ends in which one end of each of the magnetic circuits 22b and 22a is connected to the other end of the magnetic circuit 1 while the other end of each of the magnetic circuits 22b and 22a is connected to the each of the magnetic circuits 21a and 21b, one magnetic circuit 2 having both ends that are connected to a connection point of the magnetic circuits 21a and 22b and a connection point of the magnetic circuits 21b and 22a, one excitation means 3 that is provided in the magnetic circuit 2 so as to be able to generate a magnetic flux, magnetic flux detection means 4 that is provided so as to be able to detect a magnetic flux of the magnetic circuit 1, and excitation driving means for driving the excitation means 3. In the example of FIGS. 20 and 21, magnetic resistances of the magnetic circuits 21a, 21b, 22a, and 22b are appropriately selected to equalize magnetic potentials at both ends of the magnetic circuit 1, thereby exhibiting a magnetic equilibrium state in which the magnetic flux of the excitation means 3 does not exist in the magnetic circuit 1.

One of features of the example of FIGS. 20 and 21 is that, because the magnetic state of the magnetic bridge is set to the magnetic equilibrium state, the sum of magnetic fluxes passing through the magnetic flux detection means 4 becomes zero when the measured current is zero.
In the flux-gate type current sensor, the excitation magnetic flux intersects a detection coil, and output emerges from the coil even if the measured current is zero.
In other words, in the conventional method, information on the measured current and information on the always-generated excitation magnetic flux are mixed, the amount of information on the excitation magnetic flux is much larger than the amount of information on the measured current, and it is not easy to separate and taken out only the information on the measured current from all the pieces of information.

On the other hand, in the example of FIGS. 20 and 21, because the magnetic state of the magnetic bridge is set to the magnetic equilibrium state, the whole of magnitude of the detection result and the whole of a polarity component of the detection result can be regarded as the information on the measured current, and a frequency component of the detection result is information on a frequency component of the excitation magnetic flux. In the example of FIGS. 20 and 21, it is not necessary to separate the information as long as the magnitude and polarity of the detection result are utilized. As a result, a small amount of information can easily be taken out. In other words, the example of FIGS. 20 and 21 has an advantage that the current can be detected with high sensitivity.

On the other hand, the conventional sensor technologies and the example of FIGS. 20 and 21 have the common point. That is, the detection sensitivity is improved in proportion to the number of windings that is of the number of times piercing through the detected lead, and the sensitivity is improved as the number of windings of the detected lead increases. However, in the conventional sensor technologies typified by the flux-gate type current sensor, because the excitation magnetic flux is always generated in the magnetic circuit on which the detected lead is wound, an electromotive force is generated in the detected lead by the excitation magnetic flux, and the current of the electromotive force is superimposed on the measured current. The current superimposed on the measured current by the excitation magnetic flux increases relatively as the measured current decreases, and the current becomes a noise and harmful to the measured current.

It is necessary that the sensitivity is enhanced as the measured current becomes small, and it is necessary to increase the number of windings of the detected lead. However, in the conventional sensor technologies, unfortunately the current superimposed on the measured current by the excitation magnetic flux increases as the number of windings of the detected lead increases. Therefore, the problem cannot be solved. That is, in the conventional sensor technologies typified by the flux-gate type direct sensor, there is a limit on the improvement of the sensitivity by increasing the number of winding of the detected lead.

On the other hand, in the example of FIGS. 20 and 21, because the excitation magnetic flux does not exist in the magnetic equilibrium state and the magnetic reequilibrium state in the magnetic circuit on which the detected lead is wound, particularly advantageously the current superimposed on the measured current by the excitation magnetic flux is not generated. Because only the extremely small excitation magnetic flux exists in a magnetic meta-equilibrium state, the current superimposed on the measured current by the excitation magnetic flux becomes extremely small.

In the example of FIGS. 20 and 21, not only the small current can be detected even by one-time piercing of the detected lead, but also the smaller current can be detected because the number of windings of the detected lead increases easily as described above. Additionally, the noise harmful to the measured current is not generated. In the example of FIGS. 20 and 21, because the excitation magnetic flux can be operated equal to or lower than the maximum permeability of the magnetic material, a small amount of energy is required to perform the excitation, and the energy-saving current sensor can be implemented.

In the sensors proposed by the inventor, a solid-state soft magnetic material such as a ferrite core is used as the core material for the magnetic bridge. However, the solid-state soft magnetic material has an inflection point in which a permeability change associated with the increase in the magnetic field is inverted in midstream from a permeability increasing direction to a permeability decreasing direction, a region of the inflection point or less and a region exceeding the inflection point cannot be measured with the same measurement device. In other words, unfortunately the strong magnetic field (large current) cannot be measured. In the current sensor in which the magnetic bridge made of the solid-state soft magnetic material is used, although high sensitivity of several microamperes is exhibited, linearity or the offset error becomes prominent in the sensitivity of hundreds milliamperes. Particularly, an output offset caused by the residual magnetization of the soft magnetic material used in the magnetic bridge becomes troublesome.

That is, the offset amount of the sensor output cannot actually be measured in operating the sensor, and therefore correction cannot be performed. The output offset becomes largely troublesome in applications or situations in which the sensor is continuously used.

As a result of focusing on the point that the residual magnetization is caused by a magnetic wall of the soft magnetic material, the inventor obtained an idea that the core of the magnetic bridge is produced by a magnetic fluid having no magnetic wall. When the magnetic bridge was actually prepared by the magnetic fluid to experiment a magnetic-field detection capability, the offset generation was not confirmed, and it was examined that the detection can be performed to the magnetic field that is stronger than that of the solid-state soft magnetic material. The reason is as follows.

The magnetic bridge made of the magnetic fluid is identical to the magnetic bridge made of the soft magnetic material in a principle and an appearance. However, because the solid-state soft magnetic material differs from the magnetic fluid in a characteristic (hereinafter referred to as "µ-H characteristic") of "permeability (µ)" versus "magnetic field intensity (H)", the magnetic bridge made of the magnetic fluid differs from the magnetic fluid made of the solid-state soft magnetic material in a magnetic behavior.
The permeability of the solid-state soft magnetic material increases from initial permeability to maximum permeability, and the permeability decreases gently when the permeability exceeds the maximum permeability. That is, when the permeability exceeds the maximum permeability, a gradient of a characteristic curve is inverted and brought close to vacuum permeability. On the other hand, in the permeability of the magnetic fluid, the initial permeability becomes the largest, and the permeability decreases monotonously with increasing strength of the magnetic field, and the permeability is gradually brought close to the vacuum permeability. The magnetic fluid exhibits a behavior opposite the solid-state soft magnetic material at the beginning of the magnetization.

In the magnetic bridge made of the solid-state soft magnetic material, when the sum of the external magnetic field and the excitation magnetic field exceeds the magnetic field of the maximum permeability, the change in magnetic resistance is inverted, and therefore the change in output is also inverted. Therefore, it is difficult to measure the external magnetic field exceeding the maximum permeability. For example, in the actual current sensor, the strength of the magnetic field around the maximum permeability is an upper limit of the measurement of the magnetic bridge made of the solid-state soft magnetic material. That is, actually the large current cannot be measured with the current sensor in which the magnetic bridge made of the soft magnetic material is used.

On the other hand, the permeability of the magnetic fluid decreases simply with increasing magnetic field, and the permeability of the magnetic fluid has no inflection point of the gradient unlike the solid-state soft magnetic material. Accordingly, in the magnetic bridge made of the magnetic fluid, there is no limit on the measurement value due to the existence of the maximum permeability unlike the solid-state soft magnetic material. This expresses that the magnetic bridge made of the magnetic fluid is suitable to measure the strong magnetic field, that is, the large current.

In either of the magnetic bridge made of the magnetic fluid or the magnetic bridge made of the solid-state soft magnetic material, the external magnetic field has an influence on a balance of the magnetic bridge. Irrespective of the difference of the magnetic material used, the magnetic bridge made of the magnetic fluid is identical to the magnetic bridge made of the solid-state soft magnetic material in that the external magnetic field is measured by observing a degree of disruption (imbalance) of the balance.
In the magnetic bridge of the invention, the change in permeability of a bridge side (side constituting the bridge) by the external magnetic field is utilized to perform the magnetic sensing detection. Compared with the solid-state soft magnetic material, the magnetic fluid has the opposite gradient of the change in permeability, and the magnetic fluid does not have the inflection point. Therefore, the magnetic fluid differs fundamentally from the solid-state soft magnetic material in the behavior of the magnetic flux during a detection operation.
Patent Document 1: Japanese Patent Application Laid-Open No. 10-10161
Patent Document 2: Japanese Patent Application Laid-Open No. 10-332745
Patent Document 3: Japanese Patent Application Laid-Open No. 2000-55940

### DISCLOSURE OF THE INVENTION

### PROBLEM TO BE SOLVED BY THE INVENTION

In view of the fact that unfortunately the offset is generated in the conventional sensor in which the solid-state soft magnetic material is used, a problem of the invention is to provide a sensor in which the magnetic fluid is used to be able to solve the offset problem of the sensor, that is, a current sensor and a magnetic field sensor, a magnetic bridge that is formed by the magnetic fluid suitably used in the current sensor and the magnetic field sensor, and a magnetic path casing that forms the magnetic fluid whose shape is unfixed into the magnetic bridge having the required morphology.

### MEANS FOR SOLVING THE PROBLEM

In order to solve the problem, a magnetic bridge for a sensor includes: a magnetic circuit in which two separated circular magnetic paths are connected by a connection magnetic path made of a magnetic material, the circular magnetic paths being formed by retaining a shape of a magnetic fluid with a container; and an excitation coil that is driven by excitation driving means while wound on the connection magnetic path, wherein a magnetic resistance in the magnetic circuit is appropriately selected to express a magnetic equilibrium state in which a sum of magnetic fluxes of the two circular magnetic paths becomes zero (the magnetic fluxes differ from each other in a direction while being equal to each other in magnitude).

In the magnetic bridge, preferably a magnetic material of the connection magnetic path is the magnetic fluid whose shape is retained by a container. In the magnetic bridge, occasionally a magnetic gap is provided in the magnetic circuit, and preferably the magnetic gap is longitudinally disposed in a central portion of the excitation coil in order to use the magnetic circuit for the large current. This is because the gap exists for the magnetic field of the measured current while the gap does not exist in the magnetic path of the excitation magnetic field.

In the magnetic bridge, wherein the two separated circular magnetic paths made of the magnetic fluids may separately be disposed in a concentric or laminated manner, or the two separated circular magnetic paths may separately be disposed in a complex manner that is neither the concentric manner nor the laminated manner.
In the magnetic bridge, at least two magnetic materials that connect the two circular magnetic paths, preferably at least two connection magnetic paths made of the magnetic fluids may be disposed on the circular magnetic paths. The excitation coils disposed on the connection magnetic paths may be disposed on all the connection magnetic paths or may be disposed on some connection magnetic paths selected from the plural connection magnetic paths. The sensitivity can be enhanced as the number of connection magnetic paths and the number of excitation coil increase.

In the magnetic bridge, wherein the two separated circular magnetic paths made of the magnetic fluids whose shapes are retained by the container and the connection magnetic path that connects the circular magnetic paths and is made of the magnetic fluid whose shape is retained by the container are retained as morphologic magnetic paths by a magnetic path casing having the following configuration.

A magnetic path casing for a magnetic bridge in which a magnetic fluid is used, the magnetic path casing includes: a circular container body that has a partition bottom whose section is formed into a substantial H-shape; and two circular covers that are attached to openings on both sides of the container body, wherein at least one communication hole is made in the partition bottom of the container body. The magnetic fluid is accommodated in the magnetic path casing, the magnetic fluids are formed in the two separated circular magnetic paths and the connection magnetic path that connects both the circular magnetic paths, and the morphology of each of the magnetic paths are fixedly retained.
A magnetic path casing includes: two circular container bodies that become a closed section when the magnetic fluid is accommodated to attach a circular cover; and a connection magnetic path that is magnetically connected to the magnetic fluids accommodated in the two circular container bodies. In the magnetic path casing, the connection magnetic path may be made of a solid-state soft magnetic material or the magnetic fluid accommodated in a closed container casing.
In the magnetic path casing, desirably a recess is formed in an inner surface wall of the magnetic path casing and a cavity portion in which the recess is closed by a flexible film material is formed to provide a function of adjusting an inner pressure of the magnetic path casing.

### EFFECTS OF THE INVENTION

In the invention, the magnetic bridge includes the magnetic circuit in which two separated circular magnetic paths are connected by the connection magnetic path made of the magnetic material, the circular magnetic paths being formed by retaining the shape of the magnetic fluid with the container, and the excitation coil that is driven by excitation driving means while wound on the connection magnetic path, and the magnetic bridge is formed such that the magnetic resistance in the magnetic circuit is appropriately selected to express the magnetic equilibrium state in which the sum of magnetic fluxes of the two circular magnetic paths becomes zero (the magnetic fluxes differ from each other in a direction while being equal to each other in magnitude). Therefore, the circular magnetic paths in the magnetic bridge can be disposed so as to become the closed morphology around the measured current, and the detection coil is disposed on the circular magnetic path to excite the excitation coil, which allows the magnetic bridge to act as the current sensor.

The magnetic bridge of the invention is formed by the magnetic fluid that is retained by the magnetic path casing whose morphology is fixed. Accordingly, the residual magnetization does not exist, and therefore the current sensor and the magnetic field sensor in which no offset is generated can be produced and provided.

### BRIEF DESCRIPTION OF DRAWINGS

FIG. 1 is a magnetic hysteresis curve schematically illustrating a B-H characteristic of a solid-state soft magnetic material.
FIG. 2 is a magnetic hysteresis curve schematically illustrating a B-H characteristic of a magnetic fluid.
FIG. 3 is a "permeability"-"magnetic field intensity" characteristic (µ-H characteristic) curve of the solid-state soft magnetic material.
FIG. 4 is a "permeability"-"magnetic field intensity" characteristic (µ-H characteristic) curve of the magnetic fluid.
FIG. 5 is a perspective view schematically illustrating a configuration of an example of a current sensor according to the invention that is formed with a magnetic bridge of the invention.
FIG. 6 is a perspective view schematically illustrating another example of the current sensor of the invention that is magnetically equivalent to the current sensor of FIG. 5.
FIG. 7 is a schematic perspective view for explaining a configuration example that enhances sensitivity and stability as a sensor while a large-diameter circular magnetic path around a measured current is formed in the current sensor of the invention in which the magnetic bridge of the invention is used.
FIG. 8 is a perspective view schematically illustrating a modification of the example of FIG. 7.
FIG. 9 is a sectional view illustrating an assembled state of an example of a magnetic path casing that forms the magnetic bridge in which the magnetic fluid of FIG. 5 is used.
FIG. 10 is a sectional view taken on a line A-A of FIG. 9.
FIG. 11 is a sectional view taken on a line B-B of FIG. 10.
FIG. 12 is a development plan view of an example in which the current sensor of the invention is longitudinally developed.
FIG. 13 is an equivalent circuit diagram of FIG. 12.
FIG. 14 is a diagrammatic view illustrating a B-H characteristic of the magnetic bridge in a magnetic equilibrium state.
FIG. 15 is a diagrammatic view illustrating the B-H characteristic of the magnetic bridge in the presence of an external magnetic field.
FIG. 16 is a diagrammatic view illustrating a relationship between a measured current and a combined B-H characteristic.
FIG. 17 is a diagrammatic view illustrating a relationship between an excitation magnetic field of a combined B-H characteristic Bc and a magnetic flux.
FIG. 18 is a plan view of an example of magnetic field sensor according to the invention.
FIG. 19 is an equivalent circuit diagram of FIG. 18.
FIG. 20 is a magnetic circuit diagram of a morphological example in which the previously proposed current sensor is illustrated as an equivalent circuit.
FIG. 21 is an equivalent circuit diagram of the current sensor of FIG. 20.

### DESCRIPTION OF LETTERS OR NUMERALS

- MC: magnetic path casing
- 11: container body
- 11c: partition bottom
- 11d and 11e: communication hole
- 12a to 13b: recess
- mr1 and mr2: circular magnetic path
- cr1 and cr2: connection magnetic path
- L1 and L2: excitation coil
- DL: detection coil

### BEST MODE FOR CARRYING OUT THE INVENTION

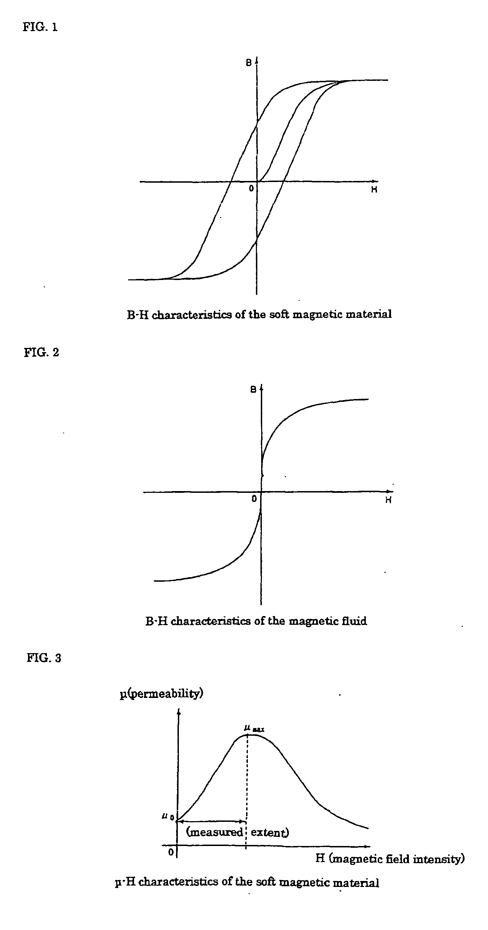

A magnetic bridge and a current sensor and a magnetic field sensor in which the magnetic bridge is used, according to an embodiment of the invention will be described below with reference to the drawings. FIG. 1 is a magnetic hysteresis curve schematically illustrating a B-H characteristic of a solid-state soft magnetic material, and FIG. 2 is a magnetic hysteresis curve schematically illustrating a B-H characteristic of a magnetic fluid.
The magnetic characteristic of the magnetic fluid of FIG. 2, in which the residual magnetization does not exist, is utilized in the embodiment of the invention.

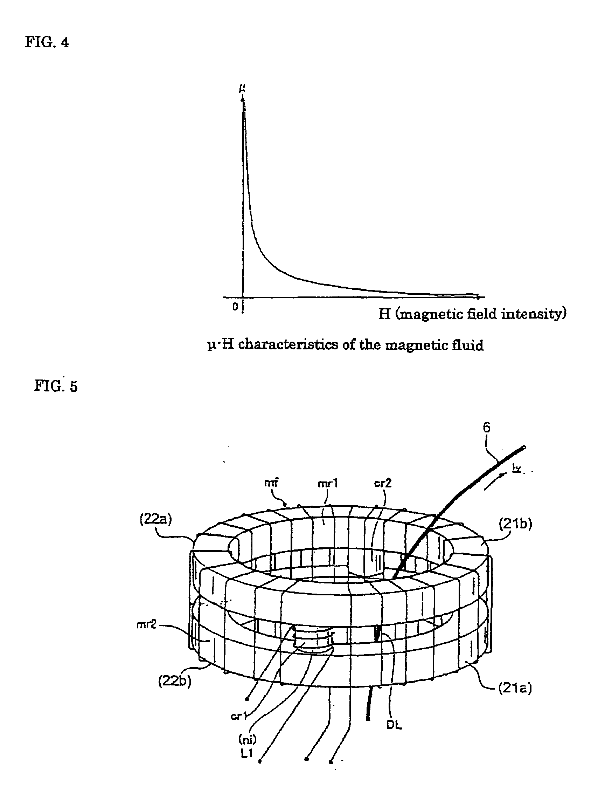

As schematically illustrated in FIGS. 3 and 4, the solid-state soft magnetic material (for example, ferrite) differs from the magnetic fluid in a gradient of the µ-H characteristic.

The magnetic fluid is called a superparamagnetic material, and the magnetic fluid has extremely high initial permeability while the permeability is rapidly lowered by a small amount of magnetization. As the magnetic field increases, the permeability is simply lowered with the vacuum permeability as an asymptotic line. The saturation magnetic field of the magnetic fluid is much higher than that of Permalloy or a silicon steel plate, the magnetic wall does not exist in the magnetic fluid, and the residual magnetization is not generated.
The characteristics of the magnetic fluid are good match with the magnetic bridge type current sensor. That is, the permeability that changes largely by the small magnetic field, the balance of the magnetic bridge is easily disrupted by the small magnetic field, and the sensitivity can be expected to be enhanced. On the other hand, the continuous change in permeability to the strong magnetic field, the single direction of the gradient of the change in permeability, and the absence of the residual magnetization are suitable to spread the dynamic range of the sensor.

The invention provides a high-sensitivity, high-accuracy current sensor and a magnetic field sensor that cannot be realized by the conventional sensor technologies using the magnetic bridge in which the characteristics of the magnetic fluid are utilized. A specific example of the sensor of the embodiment will be described with reference to FIGS. 5 to 13.

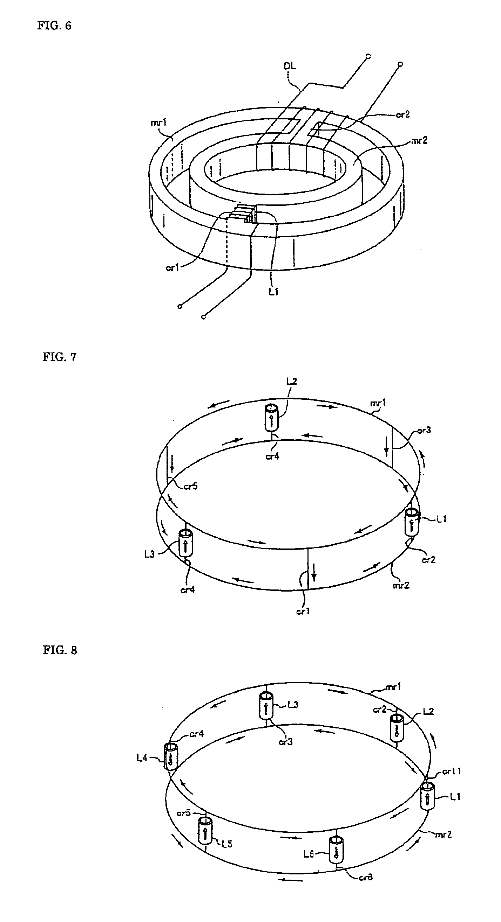

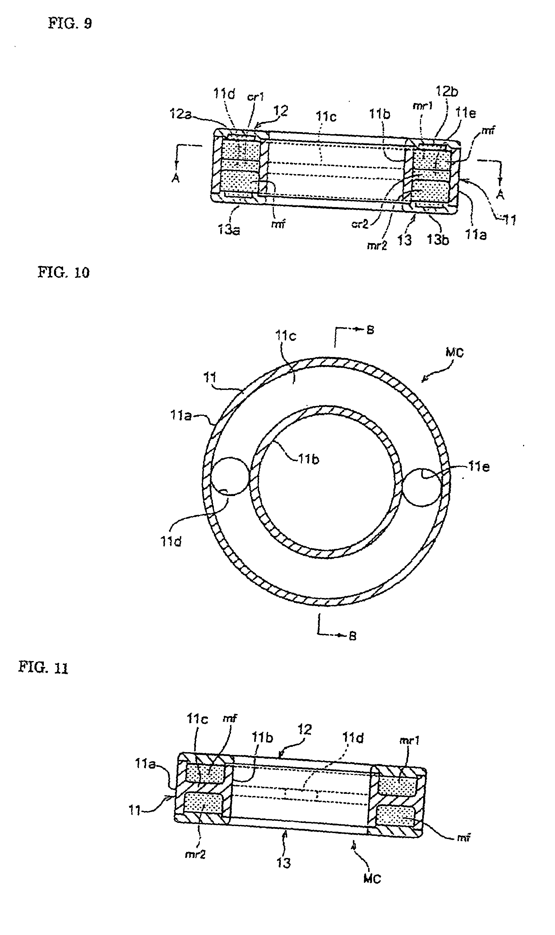

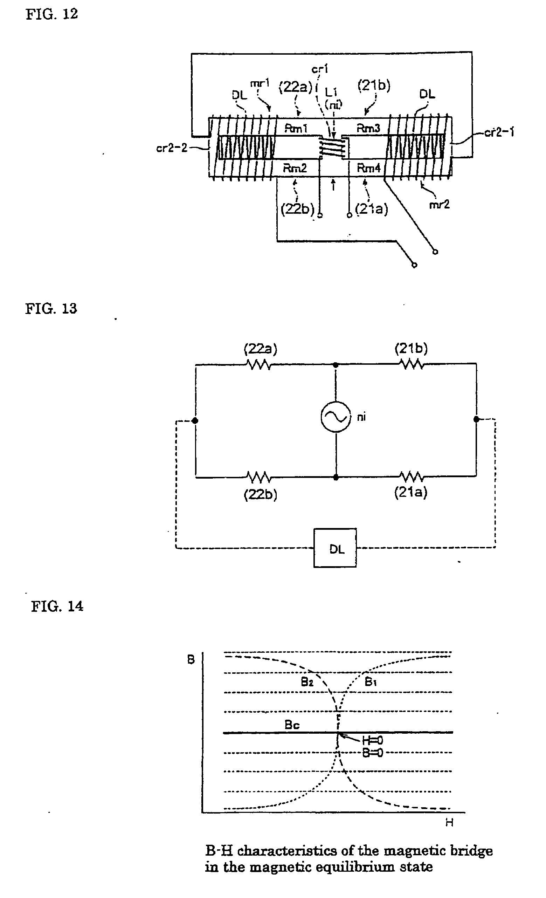

FIG. 5 is a perspective view schematically illustrating a basic configuration of a current sensor according to an embodiment of the invention that is formed with the magnetic bridge of the embodiment. FIG. 6 is a perspective view schematically illustrating a current sensor of the embodiment that is magnetically equivalent to the current sensor of FIG. 5. FIG. 7 is a schematic perspective view for explaining a configuration example of enhancing sensitivity and stability as a sensor while a large-diameter circular magnetic path around a measured current is formed in the current sensor of the embodiment in which the magnetic bridge of the embodiment is used. FIG. 8 is a perspective view schematically illustrating a modification of the example of FIG. 7. FIG. 9 is a sectional view illustrating an assembled state of an example of a magnetic path casing that forms the magnetic bridge in which the magnetic fluid of FIG. 5 is used. FIG. 10 is a sectional view taken on a line A-A of FIG. 9. FIG. 11 is a sectional view taken on a line B-B of FIG. 10. FIG. 12 is a plan view illustrating an example of the magnetic bridge of the invention in which that is used in a current sensor. FIG. 13 is an equivalent circuit diagram for explaining the magnetic bridge of FIG. 12.

Prior to the description of an embodiment of the invention, an example of the above-described current sensor previously proposed by the inventor will be described with reference to FIGS. 20 and 21.

In the current sensor of FIGS. 20 and 21, one excitation means 3 is inserted between end portions of two sets of the outer-leg magnetic circuits 21a and 21b and 22a and 22b that have a gate shape when developed, and the magnetic circuits 21a and 21b and the magnetic circuits 22a and 22b are bonded to each other.

When the measured current is passed through a detected lead 6 while magnetic bridge of the current sensor of FIGS. 20 and 21 is retained in the magnetic equilibrium state, magnetic fluxes are newly generated in the magnetic circuits 21a and 2b and 21b and 22b. It is assumed that the magnetic resistance of each magnetic circuit is Rma1 × Rma2 = Rmb1 × Rmb2. At this point, the magnetic flux passing through the intermediate-leg magnetic circuit 1 is zero when the measured current is zero. The magnetic flux passing through the intermediate-leg magnetic circuit 1 is generated when the measured current is passed through the lead 6, the change in magnetic resistance increases when the detected current increases, the disruption of the balance of the magnetic bridge also increases to increase the excitation magnetic flux passing through the intermediate-leg magnetic circuit 1.

That is, the magnitude of the excitation magnetic flux passing through the intermediate-leg magnetic circuit 1 is proportional to the magnitude of the measured current. The excitation magnetic flux generated in the intermediate-leg magnetic circuit 1 generates the electromotive force in the magnetic flux detection coil 4, and the electromotive force generated in the detection coil 4 is proportional to the magnitude of the excitation magnetic flux generated in the intermediate-leg magnetic circuit 1, so that the current sensor of FIGS. 20 and 21 can measure the current passed through the detected lead 6 by utilizing this phenomenon.

As described above, because the current sensor of FIGS. 20 and 21 detects the current by detecting the magnetic flux caused by the measured current, the magnetic bridge made of the solid-state soft magnetic material used to detect the current basically has a magnetic detection capability, and therefore the current detection capability of the current sensor depends on the magnetic detection capability of the magnetic bridge constituting the sensor.

In the conventional sensor technologies, in order to prevent the influence of the residual magnetization of the soft magnetic material as much as possible, there has also been proposed a current sensor in which the influence of the residual magnetization is prevented by selection of the soft magnetic material or control of a driving circuit. However, in the current sensor, the offset cannot be eliminated although the offset can be reduced.

Because the gradient of the corresponding curve is inverted when the µ-H characteristic of the soft magnetic material exceeds the maximum permeability, only the magnetic field can be measured up to the maximum permeability in the current sensor in which the magnetic bridge made of the solid-state soft magnetic material is used.

As described in paragraph [0018], the inventor obtained the knowledge that the offset was not generated when the magnetic field was detected with the magnetic bridge that is made of the magnetic fluid in which the residual magnetization does not exist. Unlike the soft magnetic material, because the µ-H characteristic of the magnetic fluid has the unidirectional gradient, there is no problem in the measurement of the large current that generates the strong magnetic field.

Because the magnetic fluid has a liquid form, the morphology of the magnetic fluid cannot be retained by itself. Therefore, in the invention, in order to form the magnetic bridge made of the magnetic fluid, the magnetic fluid is put into a container having an appropriate shape to form the magnetic material whose morphology is fixed, thereby forming the magnetic bridge made of the magnetic material.

First, a magnetic path casing MC according to an embodiment will be described with reference to FIGS. 9 to 11, because the magnetic path casing MC is completed as an example of the container in which the magnetic fluid is accommodated to form the magnetic bridge.
The magnetic path casing MC of FIGS. 9 to 11 includes a circular container body 11 whose section has a substantially H-shape and upper and lower covers 12 and 13 that are bonded to upper and lower circular opened surfaces of the container body 11 to form two circular magnetic paths in a closed section of the container body 11.

The circular container body 11 includes inner and outer circumferential walls 11a and 11b, a partition bottom 11c that connects opposite surfaces of the inner and outer circumferential walls 11a and 11h in an intermediate portions of heights of the inner and outer circumferential walls 11a and 11h, and two holes 11d and 11e that are made in the partition bottom 11c while separated from each other by 180 degrees. The upper and lower covers 12 and 13 are bonded to the upper and lower opened surfaces of the container body 11, and the container body 11 is partitioned by the partition bottom 11c, and upper and lower closed circular spaces (circular paths) R1 and R2 are formed while communicated with each other through the two communication holes 11d and 11e. Recesses 12a and 12b and recesses 13a and 13b are formed in the covers 12 and 13 facing the two communication holes 11d and 11e made in the partition bottom 11c. Although not illustrated, a thin film such as a flexible film which is formed on an air chamber is formed in an upper surface (opened surface) of each of the recesses 12a to 13b. Therefore, the magnetic path casing MC of the embodiment is formed. A function and a role of each configuration of the magnetic path casing MC are sequentially described.

For example, the cover 13 that constitutes the bottom is bonded to the upper and lower circular paths R1 and R2 that are communicated with each other through the two communication holes 11d and 11e in the partition bottom 11c, the magnetic fluid mf is put in the magnetic path casing MC, and the cover 12 is bonded as a top cover to seal the magnetic path casing MC. Alternatively, after the upper and lower covers 12 and 13 are bonded, the magnetic fluid mf is injected in the circular paths R1 and R2 by a syringe needle to seal the injection hole. Therefore, the two separated circular magnetic paths mr1 and mr2 are formed by the magnetic fluid mf put in the upper and lower circular paths R1 and R2. The magnetic fluid mf existing in the communication holes 11d and 11e connecting the two magnetic paths mr1 and mr2 in the partition bottom 11c constitutes the two connection magnetic paths cr1 and cr2.

In the embodiment, the recesses 12a to 13b are formed as the air chambers by forming elastic films (not illustrated) so as to cover the recesses 12a to 13b. This is because the configuration (recesses and films) corresponds to the generation of expansion or contraction of the magnetic fluid mf in the sealed magnetic path casing MC. That is, when the expansion or contraction is generated in the magnetic fluid mf, possibly the casing MC is broken. However, the extreme fluctuation of the internal pressure can be absorbed by the air (or gas) in the air chamber and the elasticity of the film. As described above, because the action of the recesses 12a to 13b and the films formed on the recesses 12a to 13b is an internal pressure adjustment in the casing magnetic path, the recesses 12a to 13b are provided in any position within the magnetic path casing MC, and it is only necessary to provide at least one recess.

The magnetic circuit that is formed by the magnetic fluid mf sealed in the magnetic path casing MC of FIGS. 9 to 11 is schematically illustrated in FIG. 5 when the magnetic path casing MC is omitted to illustrate only the magnetic fluid mf. As illustrated in FIG. 5, in the magnetic circuit, the upper and lower circular magnetic paths mr1 and mr2 and the magnetic paths mr1 and mr2 are connected by the two connection magnetic paths cr1 and cr2.

An example of the magnetic bridge of the embodiment is made of the magnetic fluid mf by placing an excitation coil L1 in the connection magnetic path cr1 of the magnetic circuit of FIG. 5. Because the magnetic bridge of the embodiment of FIG. 5 is equivalent to the magnetic bridge of the previously-proposed current sensor of FIG. 20 in the connection of the magnetic circuit (magnetic bridge of the embodiment of FIG. 5 differs from the magnetic bridge of the previously-proposed current sensor of FIG. 20 in the magnetic characteristic), the same numeral as the that of FIG. 20 is illustrated with a parenthetic numeral. Accordingly, in each magnetic circuit of FIG. 5, when the magnetic resistance is appropriately selected to pass an alternating current through the excitation coil L1, the sum of the magnetic fluxes of the two circular magnetic paths mr1 and mr2 becomes zero, that is, the two circular magnetic paths mr1 and mr2 are equal to each other in the magnitude of the magnetic flux while the circular magnetic paths mr1 and mr2 is different from each other in the orientation, so that the magnetic equilibrium state in which the sum of the magnetic fluxes becomes zero can be exhibited.

When the magnetic bridge of FIG. 5 is in the magnetic equilibrium state by passing the alternating current through the excitation coil L1, the magnetic flux is not detected by the detection coil DL even if the detection coil DL is wound on two circular magnetic paths mr1 and mr2 such that the magnetic paths mr1 and mr2 intersect each other. Accordingly, in the magnetic bridge of FIG. 5, when the lead 6 through which the measured current is passed is disposed while piercing through the two circular magnetic paths mr1 and mr2 that are laminated with the connection magnetic paths cr1 and cr2 interposed therebetween, because the new magnetic flux is generated in the magnetic bridge, the magnetic equilibrium state of the magnetic bridge is disrupted, and the circular magnetic paths mr1 and mr2 differs from each other in the excitation magnetic flux intersecting the detection coil DL, whereby the sum of the excitation magnetic fluxes does not become zero to generate the electromotive force in the detection coil DL. As a result, the current passed through the lead 6 can be measured. The same holds true for the previously-proposed current sensor.

As described above, because the magnetic fluid mf used in the magnetic bridge of the embodiment differs completely from the solid-state soft magnetic material in the B-H characteristic and the µ-H characteristic, the current sensor of the embodiment has the following feature compared with the current sensor made of the solid-state soft magnetic material. That is, first the output offset is not generated as the current sensor because the residual magnetization does not exist in the magnetic fluid, and second there is no particular limit on the measurement in the strong magnetic field of the large current because the µ-H characteristic relationship of the magnetic fluid has no inflection point (point at which the gradient is inverted at the maximum permeability) unlike the solid-state soft magnetic material. As described above, the current sensor made of the solid-state soft magnetic material can measure the current up to the maximum permeability (inflection point).

In the magnetic bridge of FIG. 5, the two circular magnetic paths mr1 and mr2 having the substantially same diameter is laminated with the connection magnetic paths cr1 and cr2 interposed therebetween. Alternatively, as illustrated in FIG. 6, the circular magnetic paths mr1 and mr2 having different diameters may concentrically be provided while connected by the connection magnetic paths cr1 and cr2. Although not illustrated, the magnetic bridge of the invention is not limited to the laminated or concentric circular magnetic paths mr1 and mr2. For example, the two circular magnetic paths having the same diameter or different diameters may be disposed while the center points are deviated, the two circular magnetic paths having the same diameter or different diameters may be disposed in a non-concentric manner, or the two circular magnetic paths having the same diameter or different diameters may be disposed while surfaces including the magnetic paths intersect each other. In FIG. 6, the same member as that of FIG. 5 and the same region as that of FIG. 5 are designated by the same numerals.

FIG. 7 illustrates a large bridge circuit, in which the large-diameter magnetic path casing is formed, the two large-diameter circular magnetic paths mr1 and mr2 are made of the magnetic fluid, and the connection magnetic paths cr1 and cr2 are connected by at least three connection magnetic paths, for example, six connection magnetic paths cr1 to cr6. Because of the many connection magnetic paths cr, three excitation coils L1 to L3 can be used as illustrated in FIG. 7, and the magnetic circuit covered by one excitation coil is shortened. Therefore, the large current sensor can be obtained with the good sensitivity and stability. Occasionally, excitation coils L1 to L6 are provided in all the magnetic paths cr1 to cr6 (see FIG. 8). This is because the sensitivity and stability increases as the sensor. In FIG. 8, each of the excitation currents is passed through the coils L1 to L6 such that the generated magnetic flux become opposite the magnetic flux generated by the adjacent coil. Because the excitation current is the alternating current, when the excitation current is passed in the opposite direction, the magnetic flux becomes the opposite direction to the direction of the magnetic flux in the positive excitation current. Arrows in the magnetic path and excitation coil of FIG. 8 indicate the orientations for the positive excitation magnetic flux.

In the current sensor of the embodiment, the magnetic gap is provided in each magnetic circuit, and the current sensors having various kinds of sensitivity can freely be designed and prepared according to the measured current by properly adjusting the magnetic gap.

The current sensor in which the magnetic bridge of the embodiment is used will be described with reference to FIGS. 5 and 12 to 17.
FIG. 12 is a development plan view of the current sensor of FIG. 5 in which the circular magnetic paths mr1 and mr2 are developed in a planar manner by longitudinally dividing the connection magnetic path cr2 into two magnetic paths cr2-1 and cr2-2 for the purpose of explanation of the magnetic bridge for the current sensor of FIG. 5. FIG. 13 is an equivalent circuit diagram of FIG. 12. A magnetic path indicated by a broken line in the equivalent circuit diagram of FIG. 13 is actually shared in the connection magnetic path cr2 of FIG. 5, and the magnetic path indicated by the broken line exists as the magnetic path having the length of zero. In FIG. 5 before the development, a detection coil DL that is illustrated while divided into both sides of FIG. 12 is continuously wound in a development position (position of connection magnetic path cr2). The beginning and the end of the winding of the detection coil DL are not limited to the positions of FIG. 5 or FIG. 12, but the beginning and the end of the winding may arbitrarily be located. The magnetic circuit of FIG. 12 constitutes a Wheatstone bridge, and the magnetic equilibrium state is established when the magnetic resistances of the magnetic circuits are Rm1 x Rm4 = Rm2 x Rm3. For the sake of convenience, the current sensor of FIG. 12 is described as the magnetic bridge of Rm1 = Rm2 = Rm3 = Rm4.

In the magnetic bridge of FIG. 12, the alternating current is passed through the excitation coil L1, the excitation magnetic flux generated in the bridge magnetic path establishes the electromotive force in the detection coil DL. The magnetic bridge of FIG. 12 is symmetrical in relation to the excitation coil L1. Therefore, the description is made using the left half of FIG. 12, that is, the magnetic resistances Rm1 and Rm2 and the left detection coil DL.
FIG. 14 illustrates a B-H characteristic of the magnetic bridge in the magnetic equilibrium state. In FIG. 14, curves B₁ and B₂ express characteristics of the magnetic resistances Rm1 and Rm2. Because the curve B₁ is a general graph, the description is omitted. The curve B₂ will be described below.

A direction of the excitation magnetic field generated downward in the excitation coil L1 is defined as a positive direction, and a direction of the magnetic field passing toward the right in the detection coil DL is defined as a positive direction. When the excitation magnetic field in the positive direction is viewed from the detection coil DL, the excitation magnetic field becomes the positive direction in the magnetic resistance Rm1, and becomes the negative direction in the magnetic resistance Rm2. That is, when the excitation magnetic field increases toward the positive direction, the excitation magnetic flux of the magnetic resistance Rm2 increases toward the negative direction. According to the definitions of the directions of the excitation magnetic field and detection coil DL, the B-H characteristic of the magnetic resistance Rm2 is turned upside down, thereby obtaining the curve B₂ of FIG. 14.

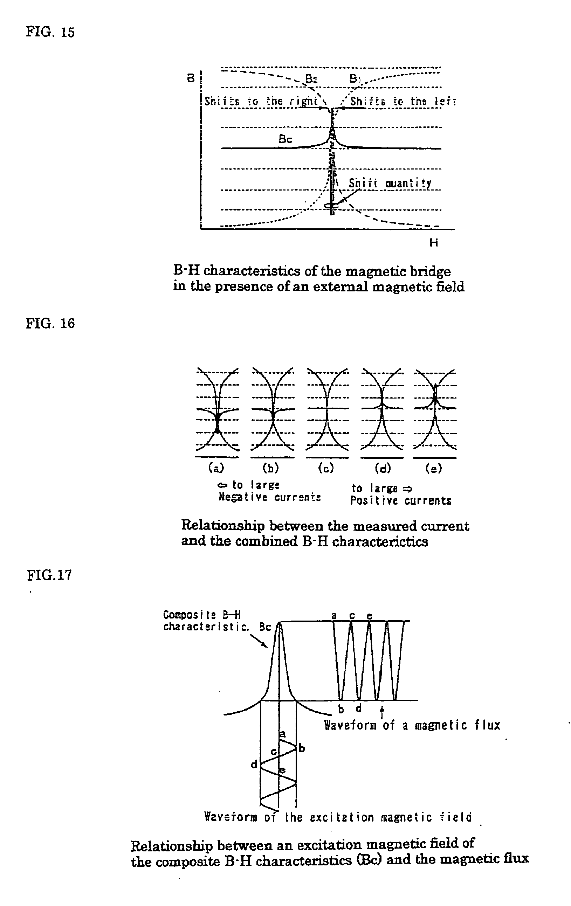

The B-H characteristic viewed from the detection coil DL is considered below. Because the magnetic resistances Rm1 and Rm2 are wound together on the detection coil DL, the B-H characteristic viewed from the detection coil DL becomes a composite of the curves B₁ and B₂. Hereinafter, the composite of the curves B₁ and B₂ is referred to as a composite B-H characteristic. Because the curve B₂ is obtained by vertically inverting the curve B₁, absolute values of the curves B₁ and B₂ are equal to each other and the composite of the curves B₁ and B₂ becomes zero in the whole region. FIG. 16 illustrates the composite B-H characteristic Bc. As can be seen from FIG. 16, the electromotive force is not generated in the detection coil DL even if the excitation is performed in any way in the magnetic equilibrium state.

It is assumed that a measured current Ix is passed through the measured lead 6 of FIG. 5 to generate the magnetic fields in the circular magnetic paths mr1 and mr2. When the measured current Ix is passed in the direction of FIG. 5, the magnetic field of the measured current Ix becomes the right magnetic field in FIG. 12. At this point, the composite B-H characteristic Bc becomes as follows. In the curve B₁, a bias is applied in the positive direction to shift the center of the excitation magnetic field toward the positive direction. Based on the excitation magnetic field, the B-H curve of the curve B₁ is shifted leftward. In the curve B₂, a bias is applied in the negative direction, and the B-H curve of the curve B₂ is shifted rightward in a way similar to the curve B₁. FIG. 15 illustrates the shift of the B-H curves of the curves B₁ and B₂.

As a result of shifting the curves B₁ and B₂, the composite B-H characteristic Bc has a projected shape with a peak of the magnetic field H = 0. In the projection of the composite B-H characteristic Bc, the sift amount and the peak increase as the measured current Ix increases.

FIG. 16 illustrates a relationship between the measured current Ix and the composite B-H characteristic Bc. FIG. 16(c) illustrates the relationship between the measured current Ix and the composite B-H characteristic Bc in the case of the measured current Ix = 0, that is, the magnetic equilibrium state. FIGS. 16(a) and 16(b) illustrate the relationships when the measured current Ix is negative, and the relationship of FIG. 16(a) is larger than the relationship of FIGS. 16(b) in the negative current value. On the other hand, FIGS. 16(d) and 16(e) illustrate the relationships when the measured current Ix is positive, and the relationship of FIG. 16(e) is larger than the relationship of FIGS. 16(d) in the positive current value. The composite B-H characteristic Bc depends on the magnitude and orientation of the measured current Ix.

FIG. 17 illustrates a relationship between the composite B-H characteristic Bc and the magnetic flux piercing through the excitation magnetic field and the detection coil DL. The excitation magnetic field oscillates around the peak point of the composite B-H characteristic Bc. Accordingly, the magnetic flux becomes the maximum when the excitation magnetic field is zero, and the magnetic flux decreases irrespective of the polarity when the excitation magnetic field is generated. As a result, two periods of the magnetic flux change in one period of the excitation magnetic field.

Thus, when the measured current Ix is passed, the output having the frequency double the excitation frequency emerges in the detection coil DL. The magnitude of the output is proportional to the magnitude of the measured current Ix, and a phase of the output depends on the orientation of the measured current Ix. Accordingly, the current can be measured by performing phase detection of the output of the detection coil DL. A bandpass filter and a resonant circuit can be used, and a full wave or a half wave may be rectified when only the information on the magnitude of the measured current Ix is obtained. The same holds true for the operation in the magnetic resistances Rm3 and Rm4.

In the current sensor of the embodiment in which the magnetic bridge made of the magnetic fluid is used, it is necessary to efficiently take the magnetic flux generated by the measured current. Therefore, the magnetic path constituting the magnetic bridge is formed in the circularly-closed circular magnetic paths mr1 and mr2.
In order to cause the magnetic bridge for the current sensor including the circular magnetic paths mr1 and mr2 to act as the magnetic field sensor, it is necessary that the circular magnetic paths mr1 and mr2 be formed into the morphology (see FIG. 12 as an example of the circular magnetic path releasing morphology) in which part of the circular magnetic path taking the magnetic flux is released to a space to efficiently take the magnetic flux of the space into the magnetic path of the magnetic bridge.

Therefore, in the magnetic bridge for the magnetic field sensor of the embodiment, as with the magnetic bridge for the current sensor of FIG. 12, the magnetic bridge of FIG. 5 is longitudinally divided by the connection magnetic path cr2, and the circular magnetic paths mr1 and mr2 are developed into the planar shape (see FIG. 18). FIG. 19 is an equivalent circuit diagram of FIG. 18. Accordingly, the magnetic bridge for the magnetic field sensor of FIG. 18 corresponds to the magnetic bridge of FIG. 12 in which the magnetic bridge for the current sensor of the embodiment is developed. However, because a magnetic path 1 indicated by a broken line in the equivalent circuit diagram of the magnetic field sensor of FIG. 19 is a magnetic path of the leak magnetic flux of the space, the magnetic path 1 does not exist actually as the magnetic material. The detected lead 6 does not exist because the equivalent circuit diagram of FIG. 19 is formed as the magnetic field sensor. Although the detection coil DL is illustrated in the magnetic path 1 in the equivalent circuit diagram, actually the detection coil DL is wound on the magnetic bridge portions (21a, 21b, 22a, and 22b).

The magnetic field sensor of the embodiment schematically illustrated in FIGS. 18 and 19 detects the magnetic field that applies the magnetic action on the sensor or the magnitude and the orientation of the magnetic flux piercing through the magnetic field sensor from the magnetic field or magnetic flux entering through the released magnetic paths cr2-1 and cr2-2 of FIG. 18. This is because the magnetic detection function is utilized in the magnetic field sensor of the embodiment like the magnetic bridge in which the current sensor of the embodiment is used. That is, in the current sensor of the embodiment of FIG. 5, the magnetic flux is generated in the magnetic circuit made of the magnetic fluid around the detected lead 6 by the weak magnetic field generated by passing the current through the detected lead 6, and the magnitude and orientation of the magnetic flux are detected by the detection coil DL wound on the magnetic bridge. In the magnetic bridge for the magnetic field sensor of FIGS. 18 and 19, the action similar to the current detection of the magnetic bridge is obtained even if the detected magnetic flux is either the external magnetic flux or the magnetic field.

Accordingly, the released magnetic paths cr1-1 and cr2-2 constituting the magnetic introduction portion are formed as illustrated in FIG. 18 so as to become part of the magnetic circuit that easily introduces the detected magnetic field to the magnetic bridge. Hereinafter, the magnetic paths cr2-1 and cr2-2 are set to the magnetic circuits 11a and 11b, the magnetic paths mr1 and mr2 are set to the magnetic circuits 21a and 21b and 21b and 22a with the magnetic path cr1 interposed therebetween, and the magnetic circuits 11a and 11b and the magnetic circuits 21a and 21b and 21b and 22a are illustrated with parentheses in FIGS. 18 and 19.

The electromotive force is not generated in the detection coil DL, when the magnetic equilibrium is established in the magnetic bridge while the external magnetic field does not exist to the magnetic bridge of the magnetic field sensor of FIGS. 18 and 19.
However, when the magnetic field sensor of FIG. 18 is exposed in the magnetic field having the directional component designated by the letter H of FIGS. 18 and 19, the magnetic fluxes are generated in the magnetic circuits 11a and 11b, and the magnetic circuits 21a, 21b and 22b, 22a that connect the magnetic circuits 11a and 11b. That is, the magnetic flux of the detected magnetic field passes through the magnetic bridge of the magnetic field sensor, and therefore the equilibrium of the magnetic bridge is disrupted by the magnetic flux passing through the magnetic bridge, and the sum of the excitation magnetic fluxes intersecting the detection coil DL does not become zero.
In FIGS. 18 and 19, the magnetic path 1 illustrated in the equivalent circuit diagram of FIG. 19 is formed as the magnetic path of the leak magnetic flux by the space.
At this point, the magnetic flux of the excitation coil L1 is the alternating magnetic flux, the magnetic flux intersecting the detection coil DL passing through the magnetic bridge also becomes the alternating magnetic flux to generate the electromotive force in the detection coil DL. The magnetic flux intersecting the detection coil DL passing through the magnetic bridge includes a large amount of frequency component double the excitation frequency of the excitation coil L1 like the current sensor of the embodiment.

The electromotive force generated in the detection coil L1 is proportional to the strength of the sum of the excitation magnetic fluxes that pass through the magnetic bridge to intersect the detection coil DL, and the strength of the sum of the excitation magnetic fluxes intersecting the detection coil DL is proportional to the strength of the excitation magnetic flux leaking from the magnetic bridge, that is, the strength of the excitation magnetic flux passing through the magnetic path 1 of FIG. 19. The strength of the excitation magnetic flux leaking from the magnetic bridge is proportional to the strength of the measured magnetic field. That is, the electromotive force that is proportional to the strength of the measured magnetic field can be obtained from the detection coil DL.

Thus, in the magnetic field sensor of the embodiment, the magnetic field strength in the space where the magnetic field sensor is placed can be detected by measuring the electromotive force of the detection coil DL. At this point, the phase of the electromotive force generated in the detection coil DL is inverted by the direction of the detected magnetic field based on the direction of the magnetic bridge connecting the magnetic circuits 11a and 11b. As a result, the magnetic field sensor can detect the direction of the magnetic field in addition to the magnetic field strength.

The magnetic field sensor in which the magnetic bridge of the embodiment is used is classified as a coil pickup sensor, and one of the features of the magnetic field sensor is that the coil pickup sensor is formed only by the coil and the magnetic material formed into a predetermined shape using the magnetic fluid. Because the magnetic fluid and the coil can be made of commercially available raw materials, the magnetic fluid and the coil are inexpensive, and a particular production facility is not required. Accordingly, the high-accuracy magnetic field sensor product can advantageously be produced and provided at low cost.

In the magnetic field sensor in which the magnetic bridge of the embodiment is used, as with the current sensor, the magnetic flux producing the desired electromotive force in the detection coil is generated by the excitation coil. As with the measured current of the current sensor, the detected magnetic field serves the function for disrupting the magnetic equilibrium of the magnetic bridge. When the magnetic equilibrium is disrupted, the sum of the magnetic fluxes intersecting the detection coil does not become zero, the magnetic flux of a difference between the magnetic fluxes intersecting the detection coil takes the morphology of the leak magnetic flux from the magnetic circuits 11a and 11b and the neighborhood of the magnetic circuits 11a and 11b with the space near the magnetic field sensor as the magnetic path. Therefore, the electromotive force of the detection coil increases with increasing excitation force of the excitation coil. At this point, the excitation magnetic flux producing the electromotive force in the detection coil can be formed much larger than the magnetic flux of the detected magnetic field.

### INDUSTRIAL APPLICABILITY

As described above, the magnetic bridge of the embodiment includes the magnetic circuit in which the two separated circular magnetic paths are connected by the connection magnetic path made of the magnetic material, the circular magnetic paths being formed by retaining the shape of the magnetic fluid with the container, and the excitation coil that is driven by the excitation driving means while wound on the connection magnetic path. In the magnetic bridge of the embodiment, the magnetic resistance in the magnetic circuit is appropriately selected to express the magnetic equilibrium state in which the sum of the magnetic fluxes of the two circular magnetic paths becomes zero (the magnetic fluxes differ from each other in a direction while being equal to each other in magnitude). Therefore, the residual magnetization does not exist and the offset is eliminated, so that the current sensor or magnetic field sensor in which the output offset is eliminated can be produced. The output-offset-free current sensor or magnetic field sensor cannot be implemented by the conventional magnetic bridge made of the solid-state soft magnetic material.

The magnetic fluid differs from the solid-state soft magnetic material in the relationship of "permeability " versus "magnetic field intensity" (µ-H characteristic), and has no inflection point. Therefore, there is no particular limit on the measured magnetic field intensity, and the measurement can be performed up to the saturation region. Accordingly, the current sensor of the embodiment has the large advantage that the large current that cannot be measured by the conventional magnetic bridge made of the solid-state soft magnetic material can be measured. Further, because the maximum permeability is infinite in principle, high sensitivity can be exhibited in the weak magnetic field, and the current sensor of the embodiment also has the large advantage that the wide dynamic range that cannot be measured by the conventional magnetic bridge made of the solid-state soft magnetic material can be measured.

## Claims

1. A magnetic bridge comprising:
a magnetic circuit in which two separated circular magnetic paths are connected by a connection magnetic path made of a magnetic material, the circular magnetic paths being formed by retaining a shape of a magnetic fluid with a container; and
an excitation coil that is driven by excitation driving means while wound on the connection magnetic path,
wherein a magnetic resistance in the magnetic circuit is appropriately selected to express a magnetic equilibrium state in which a sum of magnetic fluxes of the two circular magnetic paths becomes zero (the magnetic fluxes differ from each other in a direction while being equal to each other in magnitude).

2. The magnetic bridge according to claim 1, wherein a magnetic material of the connection magnetic path is the magnetic fluid whose shape is retained by a container.

3. The magnetic bridge according to claim 1 or 2,
wherein the magnetic circuit has a magnetic gap.

4. The magnetic bridge according to claim 3, wherein the magnetic gap is disposed in a direction in which the magnetic gap longitudinally traverses the connection magnetic path.

5. The magnetic bridge according to claim 3, wherein the magnetic gap is disposed in a direction in which the magnetic gap crosses the connection magnetic path.

6. The magnetic bridge according to any one of claims 1 to 5, wherein the two separated circular magnetic paths are disposed in a concentric, laminated, non-concentric, or non-laminated manner, and are connected by the connection magnetic path.

7. The magnetic bridge according to any one of claims 1 to 6, wherein at least two connection magnetic paths that connect the two circular magnetic paths are disposed on the circular magnetic paths.

8. The magnetic bridge according to any one of claims 1 to 7, wherein excitation coils which are disposed on connection magnetic paths are disposed on all the connection magnetic paths or are disposed on some connection magnetic paths selected from the plurality of connection magnetic paths.

9. The magnetic bridge according to any one of claims 2 to 7, wherein the two separated circular magnetic paths made of the magnetic fluids whose shapes are retained by the container and the connection magnetic path that connects the circular magnetic paths and is made of the magnetic fluid whose shape is retained by the container are retained as morphologic magnetic paths by a magnetic path casing that is of the container retaining the shape of the magnetic fluid.

10. A magnetic path casing for a magnetic bridge in which a magnetic fluid is used, the magnetic path casing comprising:
a circular container body that has a partition bottom whose section is formed into a substantial H-shape; and
two circular covers that are attached to openings on both sides of the container body,
wherein at least one communication hole is made in the partition bottom of the container body.

11. A magnetic path casing for a magnetic bridge in which a magnetic fluid is used, the magnetic path casing comprising:
two circular container bodies that become a closed section when the magnetic fluid is accommodated to attach a circular cover; and
a connection magnetic path that is magnetically connected to the magnetic fluids accommodated in the two circular container bodies.

12. The magnetic path casing according to claim 11, wherein the connection magnetic path is made of a solid-state soft magnetic material or the magnetic fluid accommodated in a closed container casing.

13. The magnetic path casing according to any one of claims 10 to 12, wherein a recess is formed in an inner surface wall of the magnetic path casing and the recess is closed by a film.

14. A current sensor comprising:
a magnetic bridge according to any one of claims 1 to 8; and
a detection coil that is wound on a magnetic circuit of the magnetic bridge,
wherein when a magnetic resistance in the magnetic circuit is appropriately selected to express a magnetic equilibrium state in which a sum of magnetic fluxes of the two circular magnetic paths becomes zero (the magnetic fluxes differ from each other in a direction while being equal to each other in magnitude), a detected lead that pierces through the circular magnetic path is disposed in the circular magnetic path to measure a measured current passing through the lead.

15. A magnetic field sensor comprising:
a magnetic circuit in which two linear magnetic paths are disposed in parallel, a shape of a magnetic fluid being retained by a container in the two linear magnetic paths, and corresponding central regions and both end regions of the two magnetic paths are connected by connection magnetic paths; and
an excitation coil that is driven by excitation driving means while wound on the connection magnetic path,
wherein a detection coil is wound on a magnetic bridge in which a magnetic resistance in the magnetic circuit is appropriately selected to express a magnetic equilibrium state in which a sum of magnetic fluxes of the two circular magnetic paths becomes zero (the magnetic fluxes differ from each other in a direction while being equal to each other in magnitude), and
the two linear magnetic paths are exposed to a measured magnetic field to measure the measured magnetic field.
